# EUROPEAN PATENT APPLICATION

(11) **EP 4 390 544 A1**
(43) Date of publication of application: **26.06.2024**
(21) Application number: 22216652.2
(22) Date of filing: 23.12.2022
(51) Int. Cl.: G03F 7/00, G02B 27/64

(54) **OPTICAL SYSTEM**

(71) Applicant: ASML Netherlands B.V., 5500 AH Veldhoven (NL)
(72) Inventor: VAN GOCH, Bram, Paul, Theodoor, 5500 AH Veldhoven (NL); VAN KEMENADE, Johannes, Marinus, 5500 AH Veldhoven (NL); VAN DE RUIT, Kevin, 5500 AH Veldhoven (NL)
(74) Representative: ASML Netherlands B.V.

(57) **Abstract**

An optical system comprises at least one position sensor and adjustable optics and is arranged to receive a radiation beam and to direct the radiation beam to an illumination region. The at least one position sensor is operable to determine a position of part of the optical system. The adjustable optics is configured to control an optical path of the received radiation beam in dependence on the determined position of the part of the optical system. The adjustable optics may be configured to at least partially correct for any variations in a spatial and/or angular distribution of the radiation at the illumination region that result from any deviations in the determined position from a nominal position. The optical system may comprise an illumination system for an imaging apparatus (for example a lithographic apparatus). A corresponding method of providing radiation to an illumination region via an optical system is also claimed.

## Description

### FIELD

The present invention relates to an optical system for delivering a radiation beam to an illumination region. The optical system may be an illumination system within a lithographic apparatus. The present invention also relates to a corresponding method of providing radiation to an illumination region via an optical system. The method may form part of a lithographic exposure method.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

Within a lithographic apparatus, the radiation is delivered to the patterning device by an optical system, which may be referred to as an illumination system. The illumination system may be arranged to condition the radiation beam such that it is delivered to the patterning device with desired spatial and angular distributions. It may be desirable to provide alternative apparatus and methods for delivering radiation to an exposure region or patterning device that at least partially addresses one or more problems in prior art arrangements, whether identified herein or otherwise.

### SUMMARY

According to a first aspect of the present disclosure there is provided an optical system for use in an imaging apparatus, the optical system arranged to receive a radiation beam (provided by a radiation source) at an inlet and to direct the radiation beam to an illumination region via an optical path, the optical system comprising: at least one position sensor operable to determine a position and/or orientation of at least a part of the optical system; and adjustable optics configured to control the optical path of the received radiation beam in dependence on a determined position and/or orientation of the part of the optical system.

During use, if the at least a part of the optical system moves then the spatial and/or angular distribution of radiation delivered to the illumination region may be changed, which may be undesirable. The optical system according to the first aspect is advantageous, as it allows for any movement (or variation in position and/or orientation) of the at least a part of the optical system to be corrected for such that the radiation is delivered to the illumination region accurately.

The optical system may be suitable for use in a lithographic apparatus. The optical system may comprise an illumination system for an imaging apparatus (for example a lithographic apparatus). Such an illumination system may be operable to condition a received radiation beam (for example from a radiation source or laser) and so as to deliver the received radiation to an illumination region (in which a mask or reticle may be disposed) with a desired or required spatial and angular distribution.

The optical system according to the first aspect is particularly beneficial for use in the illumination system of a lithographic apparatus, as now discussed.

For a precision imaging apparatus such as a lithographic apparatus it can be extremely important to illuminate a patterning device (also referred to as a mask or a reticle) with radiation having well-defined spatial and angular distributions. For example, it is generally desirable to illuminate the patterning device with a generally uniform spatial distribution to ensure that the dose of radiation delivered to a substrate (for example a resist-coated silicon wafer) is well controlled. In turn, this can result in better critical dimension (CD) control. The angular distribution of radiation at the illumination region (in which the patterning device is disposed) may also be referred to as an illumination mode or a pupil. The angular distribution radiation at the illumination region (in which the patterning device is disposed) describes how a cone of radiation that illuminates each portion of the patterning device is filled. This can be described by the intensity of radiation in an entrance pupil of the projection optics arranged to image the patterning device onto the substrate. It is generally known that illuminating a patterning device with an illumination mode wherein peripheral portions of the entrance pupil are illuminated and central portions of the entrance pupil are not illuminated (for example annular illumination modes and dipole illumination modes) can generally improve the contrast of the image formed on the substrate for a range of different features (relative, for example, to a full pupil fill illumination).

Any variation in the position and/or angle of the radiation delivered to a patterning device may affect the imaging of the patterning device onto the substrate. In particular, any pointing error of the radiation delivered to the illumination region can result in asymmetric numerical aperture (NA) clipping, particularly for illumination modes in which the outermost portions of the entrance pupil are illuminated (for example extreme dipoles). In turn, this will adversely affect the imaging of the patterning device, which is undesirable. It will be appreciated that the projection system of a lithographic apparatus will, in general, provide numerical aperture clipping of the radiation beam patterned by a mask or patterning device. In practice, the lithographic apparatus is used to image features which are small in comparison to the wavelength of the radiation beam and therefore the image of the pattern formed on the wafer is typically diffraction-limited, formed only from a very small number of diffraction orders of the radiation that has interacted with the mask. However, any asymmetric numerical aperture clipping of the radiation beam by the projection system can result in alignment errors. Slow changes in the (symmetry) of the NA clipping result in position errors ( i.e., a moving average) of the image formed on the wafer whereas fast changes in the clipping are smeared out, contributing to a blurring (an increase in mean standard deviation) of features formed on the wafer. It will be appreciated that as used here "slow" may mean over time scales that are large in comparison to an exposure time of the wafer and "fast" may mean over time scales that are smaller than an exposure time of the wafer.

The adjustable optics may be configured to control the optical path of the received radiation beam in dependence on a determined position and/or orientation of the part of the optical system so as to at least partially correct for any variations in a spatial and/or angular distribution of the radiation at the illumination region that result from any deviations in the determined position and/or orientation from a nominal position.

For example, the optical system may have a nominal position. When disposed in the nominal position, the position and direction of radiation delivered to the illumination region may be optimum. In use, the optical system may be subject to vibrations. For example, for embodiments wherein the optical system is, or forms part of, an illumination system for a lithographic apparatus, movement of other parts of the lithographic apparatus in use may cause some vibrations of the optical system.

Any deviations in the determined position and/or orientation from a nominal position may result in sub-optimal irradiation of the illumination region and therefore, for such embodiments, the adjustable optics are used to at least partially correct for any variations.

To the extent possible, the adjustable optics may be configured such that a spatial and/or angular distribution of the radiation at the illumination region is generally independent of the determined position of the part of the optical system.

The optical system may further comprise a radiation beam measurement sensor operable to determine a position and/or a direction of the received radiation beam relative to at least a part of the optical system. The adjustable optics may be operable to control the optical path of the received radiation beam in dependence on the determined position and/or direction of the received radiation beam relative to said at least a part of the optical system.

That is, the radiation beam measurement sensor may be used to align a received radiation beam to the optical system (using the adjustable optics). This can correct for any alignment and/or pointing errors of a radiation beam received by the optical system. However, with such an arrangement, if the optical system itself moves, then the radiation beam will also move and therefore the radiation beam will not be accurately aligned with the illumination region. However, since the adjustable optics are configured to control the optical path of the received radiation beam in dependence on a determined position of the part of the optical system, any misalignment between the radiation beam and the illumination region can be corrected for.

The at least a part of the optical system relative to which the radiation beam measurement sensor is operable to determine a position and/or a direction of the received radiation beam may be the same part of the optical system that the at least one position sensor operable to determine a position and/or orientation of.

Alternatively, in some embodiments, the at least a part of the optical system relative to which the radiation beam measurement sensor is operable to determine a position and/or a direction of the received radiation beam may be a different part of the optical system to the part of the optical system that the at least one position sensor operable to determine a position and/or orientation of. For example, in one embodiment, the radiation beam measurement sensor may be operable to determine a position and/or a direction of the received radiation beam relative to a part of the optical system proximate the inlet and the at least one position sensor may be operable to determine a position and/or orientation of a part of the optical system proximate the illumination region.

Note that the same actuatable or adjustable optical elements may be used to both: (a) control the optical path of the received radiation beam in dependence on a determined position and/or orientation of part of the optical system; and (b) control the optical path of the received radiation beam in dependence on a determined position and/or a direction of the received radiation beam. Alternatively, a first set of optical elements may be provided to control the optical path of the received radiation beam in dependence on a determined position and/or orientation of part of the optical system and a second set of optical elements may be provided to control the optical path of the received radiation beam in dependence on a determined position and/or direction of the received radiation beam. For such embodiments, the adjustable optics may be considered to comprise both the first set of optical elements and the second set of optical elements.

The optical system may comprise a plurality of position sensors and the adjustable optics may be operable to control the optical path of the received radiation beam in dependence on a position and/or orientation of a part of the optical system determined by each of the plurality of position sensors.

This may allow for more complicated distortions of the optical system to be corrected for. For example if the optical system does not merely oscillate as a whole but is subject to vibration or oscillation modes that correspond to a distortion of the optical system.

The at least one position sensor is operable to determine a position and/or orientation of at least a part of the optical system. Such a determination may be a direct measurement of position and/or orientation. Alternatively, the determination may be indirect. For example, the position sensor may measure another quantity (for example acceleration) from which a position and/or orientation can be determined. Any suitable type of position sensor may be used. In general, each position sensor determines a position and/or orientation of the part of the optical system relative to a reference frame. The reference frame may be any frame in which the illumination region (also referred to in the art as the illumination slit or just slit) is stationary.

In some embodiments, the at least one position sensor is operable to determine a position and/or orientation of at least a part of the optical system in all six degrees of freedom.

The or each position sensor may comprise one or more accelerometers.

Such embodiments determine the position and/or orientation of parts of the optical system relative to an inertial frame.

In one embodiment, the or each position sensor may comprise at least two accelerometers arranged to determine an acceleration of a part of the optical system in at least in two directions that are generally orthogonal to the optical path. This allows a position of the part of the optical to be determined in said two directions that are generally orthogonal to the optical path. In one embodiment, the or each position sensor may comprise at least three accelerometers arranged to determine an acceleration of a part of the optical system in three linearly independent directions. This allows a position of the part of the optical to be determined in said three linearly independent directions.

In some embodiments the or each accelerometer is operable to determine acceleration and/or position and has three degrees of freedom. In one embodiment, the position sensor comprises two or three accelerometers, each arranged to determine three degrees of freedom. Advantageously, this may allow the position sensor to determine a position and/or orientation of at least a part of the optical system in all six degrees of freedom.

Alternative position sensors may include interferometric sensors. Such interferometric sensors may, for example, be of the type used to monitor the position of a reticle stage or wafer stage in a lithographic apparatus.

At least one position sensor may be optically downstream of the adjustable optics.

Advantageously, this may allow for the at least one position sensor to be as close as possible to the illumination region. In turn, this may result in more accurate control of the spatial and angular distributions of the radiation at the illumination region.

The optical system may further comprise a controller operable to: receive a first signal from the or each position sensor indicative of a position and/or orientation of a part of the optical system; and generate and send a control signal to the adjustable optics, the control signal dependent on the first signal(s).

The controller may be further operable to receive a second signal from the radiation beam measurement sensor indicative of a position and/or or a direction of the received radiation beam relative to the optical system; and the control signal may be dependent on the first signal(s) and the second signal.

The optical system may further comprise beam steering optics that are arranged to direct the radiation along an adjustable optical path.

The beam steering optics may receive a radiation beam (for example from a radiation source). The beam steering optics may, for example, comprise two rotatable mirrors. By rotating the mirrors a position and direction of the radiation beam downstream of the beam steering optics can be controlled.

The adjustable optics may comprise the beam steering optics.

The optical system may comprise pupil shaping optics that are operable to control an angular distribution of radiation delivered to the illumination region.

That is, the illumination region may be irradiated using different illumination modes or pupils by selecting one or a plurality of configurations of the pupil shaping optics.

The pupil shaping optics may comprise a mirror array comprising a plurality of independently adjustable mirrors.

The adjustable optics may comprise the pupil shaping optics.

According to a second aspect of the present disclosure there is provided a lithographic apparatus comprising: the optical system according to the first aspect of the present disclosure operable to receive radiation and to direct at least a portion of the received radiation to the illumination region; a support structure configured to support a patterning device such that the patterning device is positionable in the illumination region; a substrate table configured to support a substrate; and a projection system operable to form an image of a patterning device supported by the support structure on a substrate supported by the substrate table.

The lithographic apparatus according to the second aspect is advantageous, as it allows for any movement (or variation in position) of the at least a part of the optical system to be corrected for such that the radiation is delivered to the illumination region (where the patterning device is, in use, positioned) more accurately. In turn, as explained above, any variation in the position and/or angle of the radiation delivered to a patterning device may affect the imaging of the patterning device onto the substrate. In particular, any pointing error of the radiation delivered to the illumination region can result in asymmetric numerical aperture (NA) clipping, particularly for illumination modes in which the outermost portions of the entrance pupil are illuminated (for example extreme dipoles). In turn, this will adversely affect the imaging of the patterning device, which is undesirable. The lithographic apparatus according to the second aspect allows for a greater range of illumination modes to be used without suffering from such problems (for example asymmetric NA clipping). Additionally or alternatively, the lithographic apparatus according to the second aspect allows for larger movement or vibrations of parts of the lithographic apparatus without suffering from such problems (for example asymmetric NA clipping). In turn, tolerating larger movement or vibrations can, advantageously, allow for an increase in throughput of the lithographic apparatus and the associated reduction in manufacturing costs per wafer.

According to a third aspect of the present disclosure there is provided a method of providing radiation to an illumination region via an optical system the method comprising: determining a position and/or orientation of at least a part of the optical system; and adjusting at least one optical element in the optical system in dependence on a determined position of a part of the optical system.

The method according to the third aspect may be carried out using the optical system according to the first aspect. The method according to the third aspect is advantageous, as it allows for any movement (or variation in position and/or orientation) of the at least a part of the optical system to be corrected for such that the radiation is delivered to the illumination region accurately.

The method according to the third aspect is particularly beneficial for use in illuminating a patterning device (also referred to as a reticle or a mask) as part of a lithographic exposure process. For example, any variation in the position and/or angle of the radiation delivered to a patterning device may affect the imaging of the patterning device onto the substrate. In particular, any pointing error of the radiation delivered to the illumination region can result in asymmetric numerical aperture (NA) clipping, particularly for illumination modes in which the outermost portions of the entrance pupil are illuminated (for example extreme dipoles). In turn, this will adversely affect the imaging of the patterning device, which is undesirable.

Adjusting at least one optical element in the optical system in dependence on a determined position and/or orientation of a part of the optical system may comprise at least partially correcting for any variations in a spatial and/or angular distribution of the radiation at the illumination region that result from any deviations in the determined position and/or orientation from a nominal position.

For example, the optical system may have a nominal position. When disposed in the nominal position, the position and direction of radiation delivered to the illumination region may be optimum. In use, the optical system may be subject to vibrations. For example, for embodiments wherein the optical system is, or forms part of, an illumination system for a lithographic apparatus, movement of other parts of the lithographic apparatus in use may cause some vibrations of the optical system.

Any deviations in the determined position and/or orientation from a nominal position may result in sub-optimal irradiation of the illumination region and therefore, for such embodiments, the at least one optical element (which may be referred to as adjustable optics) are used to at least partially correct for any variations.

To the extent possible, adjusting the at least one optical element in the optical system in dependence on a determined position and/or orientation of a part of the optical system may be performed such that a spatial and/or angular distribution of the radiation at the illumination region is generally independent of the determined position of the part of the optical system.

The method may further comprise: providing a radiation beam; determining a position and/or a direction of the provided radiation beam relative to at least a part of the optical system; and adjusting at least one optical element in the optical system in dependence on a determined position and/or direction of the provided radiation beam relative to said at least a part of the optical system.

The method may comprise: determining a position and/or orientation of a plurality of parts of the optical system; and adjusting at least one optical element in optical system in dependence on the determined positions and/or orientations of each of the plurality of parts of the optical system.

This may allow for more complicated distortions of the optical system to be corrected for. For example if the optical system does not merely oscillate as a whole but is subject to vibration or oscillation modes that correspond to a distortion of the optical system.

At least one part of the optical system the position and/or orientation of which is determined may be optically downstream of the at least one optical element adjusted in dependence thereon.

Advantageously, this may allow for the at least one part of the optical system the position and/or orientation of which is determined to be as close as possible to the illumination region. In turn, this may result in more accurate control of the spatial and angular distributions of the radiation at the illumination region.

The method may further comprise conditioning the radiation beam so as to control a spatial and/or an angular distribution of radiation delivered to the illumination region.

According to a fourth aspect of the present disclosure there is provided a lithographic exposure method, the method comprising: providing a patterning device in an illumination region; providing radiation to the illumination region via an optical system using the method of the third aspect of the present disclosure so as to form a patterned radiation beam; and collecting the patterned radiation beam and using it to form an image of the patterning device on a substrate.

The lithographic exposure method according to the fourth aspect is advantageous, as it allows for any movement (or variation in position and/or orientation) of the at least a part of the optical system to be corrected for such that the radiation is delivered to the illumination region (where the patterning device is provided) more accurately. In turn, as explained above, any variation in the position and/or angle of the radiation delivered to a patterning device may affect the imaging of the patterning device onto the substrate. In particular, any pointing error of the radiation delivered to the illumination region can result in asymmetric numerical aperture (NA) clipping (at the step of collecting the patterned radiation beam), particularly for illumination modes in which the outermost portions of the entrance pupil are illuminated (for example extreme dipoles). In turn, this will adversely affect the imaging of the patterning device, which is undesirable. The lithographic exposure method according to the fourth aspect allows for a greater range of illumination modes to be used without suffering from such problems (for example asymmetric NA clipping). Additionally or alternatively, the lithographic exposure method according to the fourth aspect allows for larger movement or vibrations of parts of the lithographic apparatus without suffering from such problems (for example asymmetric NA clipping). In turn, tolerating larger movement or vibrations can, advantageously, allow for an increase in throughput of the lithographic apparatus and the associated reduction in manufacturing costs per wafer.

The exposure may be a scanning exposure such that providing the patterning device in the illumination region may comprise moving the patterning device through the illumination region and forming an image of the patterning device on the substrate may comprise moving the substrate such that the image of the patterning device is generally stationary relative to the substrate.

### BRIEF DESCRIPTION OF THE DRAWINGS

Embodiments of the invention will now be described, by way of example only, with reference to the accompanying schematic drawings, in which:
- Figure 1 depicts a first schematic overview of a lithographic apparatus;
- Figure 2 depicts a second schematic overview of a lithographic apparatus;
- Figure 3 is a schematic view of an optical system according to an embodiment of the present disclosure that may form part of the lithographic apparatus shown in Figure 1 and/or Figure 2, the optical system being shown in a first, nominal position and/or configuration;
- Figure 4A shows the optical system shown in Figure 3 in a second, non-nominal, or distorted, position and/or configuration;
- Figure 4B shows the optical system shown in Figure 3 in the second, non-nominal, or distorted, position and/or configuration (as also shown in Figure 4A) and wherein the adjustable optics have been used to at least partially correct for the effect that the variation from the first, nominal position and/or configuration (see Figure 3) may have on a spatial and/or angular distribution of radiation at the illumination region;
- Figure 5 is a schematic illustration of a first method of providing radiation to an illumination region via an optical system according to an embodiment of the present disclosure;
- Figure 6 is a schematic illustration of a second method of providing radiation to an illumination region via an optical system according to an embodiment of the present disclosure; and
- Figure 7 is a schematic illustration of a lithographic exposure method according to an embodiment of the present disclosure, which may comprise the method of Figure 5 and/or Figure 6.

### DETAILED DESCRIPTION

In the present document, the terms "radiation" and "beam" are used to encompass all types of electromagnetic radiation, including ultraviolet radiation ( e.g., with a wavelength of 365, 248, 193, 157 or 126 nm) and EUV (extreme ultra-violet radiation, e.g., having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

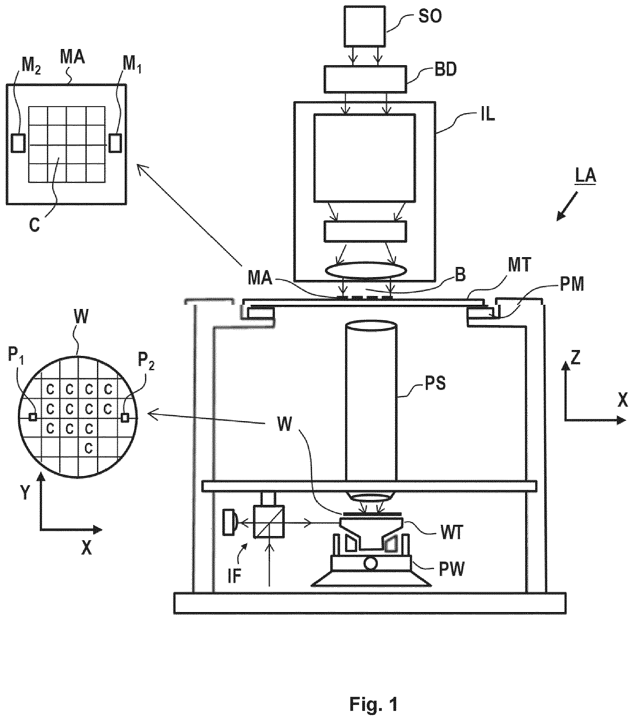

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g., mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

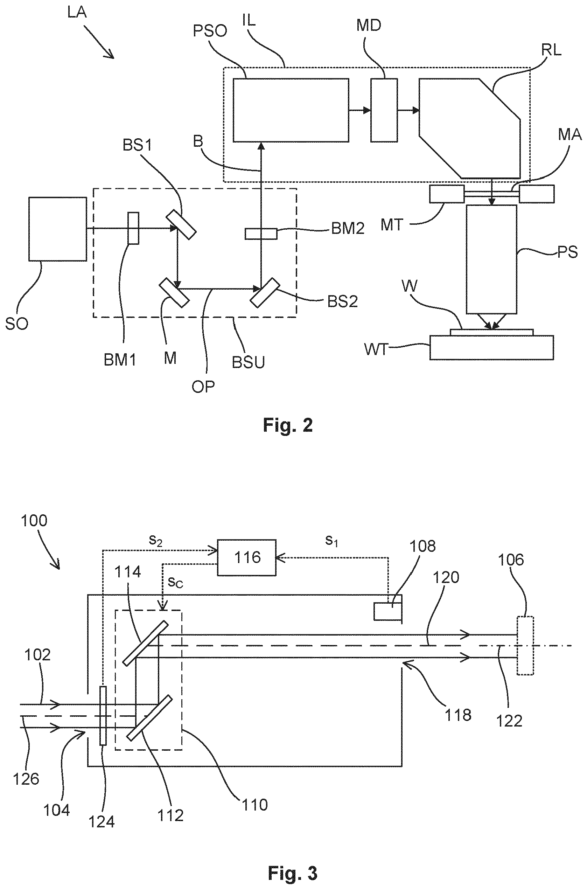

Figure 2 is a second schematic depiction of a lithographic apparatus LA. The lithographic apparatus LA shown in Figure 2 is generally of the form of the lithographic apparatus LA shown in Figure 1. In particular, the lithographic apparatus LA shown in Figure 2 also comprised: an illumination system IL configured to condition a radiation beam B; a mask support MT constructed to support a patterning device MA; a substrate support WT constructed to hold a substrate W; and a projection system PS configured to project a pattern imparted to the radiation beam B by patterning device MA onto a target portion of the substrate W. The lithographic apparatus LA shown in Figure 2 may comprise any of the features discussed above in connection with the lithographic apparatus LA shown in Figure 1.

In use, the illumination system IL receives a radiation beam B from a radiation source SO via a beam steering unit BSU. The beam delivery system BD shown in Figure 1 may be generally equivalent to the beam steering unit BSU shown in Figure 2.

The beam steering unit BSU is operable to receive a radiation beam from the radiation source SO and to deliver the radiation beam to the illumination system IL via an adjustable optical path OP. Adjustability of the optical path OP is achieved by (at least) two beam steering mirrors BS1, BS2, which form part of the optical path OP. Each of the beam steering mirrors BS1, BS2 can be rotated so as to alter the optical path OP. The beam steering unit BSU further comprises (at least) two beam measuring sensors BM1, BM2. Each of the beam measuring sensors BM1, BM2 is operable to measure a position of the radiation beam B (relative to the beam steering unit BSU) as it propagates along the optical path OP.

In use, the two beam measuring sensors BM1, BM2 and the two beam steering mirrors BS1, BS2 may be used as a feedback loop, as follows. The beam measuring sensors BM1, BM2 may be used to determine any deviations of the optical path OP of the radiation beam B from an optimal or nominal optical path of the radiation beam B as it leaves the beam steering unit and enters the illumination system IL. These measurements may be used to control the orientation of the two beam steering mirrors BS1, BS2 so as to reduce any such deviations of the optical path OP of the radiation beam B from an optimal or nominal optical path of the radiation beam B as it leaves the beam steering unit and enters the illumination system IL. This may be achieved using a control loop algorithm, for example executed by a controller that may be operable to receive signals from the beam measuring sensors BM1, BM2 and to send control signals to the beam steering mirrors BS1, BS2. In this way, the beam steering unit BSU may be operable to maintain a position and orientation of the radiation beam B as it exits the beam steering unit BSU (and enters the illumination system IL) substantially independent of the position and orientation of the radiation beam B as it enters the beam steering unit BSU.

In addition to the optical components mentioned above, the beam steering unit BSU further comprises a mirror M which also forms part of the optical path OP. It will be appreciated that in other embodiments such a mirror M may not be present and further that in still other embodiments the beam steering unit BSU may further comprise one or more additional optical components.

In this embodiment, the illumination system IL comprises: pupil shaping optics PSO; a masking device MD; and relay optics RL.

The pupil shaping optics PSO are operable to control an angular distribution of radiation delivered to an illumination region in a plane of the patterning device MA. That is, the illumination region may be irradiated using different illumination modes or pupils by selecting one or a plurality of configurations of the pupil shaping optics PSO. The pupil shaping optics PSO may, for example, comprise a mirror array comprising a plurality of independently adjustable mirrors. By controlling the orientation of the plurality of independently adjustable mirrors an illumination mode (or pupil shape) of the radiation beam at the patterning device MA can be controlled.

The masking device MD is operable to control an extent of an illumination region in the plane of the patterning device MA. For example, the masking device MD may comprise two pairs of masking blades, each pair of masking blades arranged to define an extent of the illumination region in a different one of two directions in the plane of the patterning device MA. For, the masking device MD may comprise: a pair of x masking blades arranged to define an extent of the illumination region in a first direction in the plane of the patterning device MA; and a pair of y masking blades arranged to define an extent of the illumination region in a second direction in the plane of the patterning device MA. The masking device MD may be arranged such that during exposure of one target region of the substrate W, adjacent target regions of the substrate W do not receive radiation.

In some embodiments the lithographic apparatus LA may be a scanning lithographic apparatus LA (also known simply as a scanner). In a scanner, an extent of a pattern on the patterning device MA in a scanning direction may be greater than that of the illumination region in the plane of the patterning device MA. In order to image the pattern onto a target region of the substrate W, the patterning device is moved or scanned through the illumination region in the scanning direction. It will be appreciated that the substrate W is also scanned relative to an illumination region in the plane of the substrate W. The movement of the substrate W is such than an aerial image of the patterning device MA is static relative to the substrate W and it will be appreciated that a direction and speed of the substrate W may, in general, differ from that of the patterning device MA (for example if the image is inverted and/or if a reduction faction is applied by the projection system PS).

In embodiments wherein the lithographic apparatus LA is a scanning lithographic apparatus, the masking blades that define the extent of the illumination region in the scanning direction (which may be the y masking blades) may move during a scanning exposure of one target region of the substrate W such that adjacent target regions of the substrate W do not receive radiation.

The relay optics RL are arranged to image the masking device MD (or the masking blades thereof) onto the plane of the patterning device MA. That is, the relay optics RL may ensure that a plane of the masking device MD (or the masking blades thereof) is conjugate to the plane of the patterning device MA (and the substrate W). Such a plane that is conjugate to the plane of the patterning device MA (and the substrate W) may be referred to as a field plane. This ensures that the masking device MD is sharply imaged onto the substrate, which minimises the amount of radiation received by adjacent target regions when any given target region is being exposed to the radiation beam B.

Some known lithographic apparatus LA use a beam steering unit BSU of the type shown in Figure 2 and described above to at least partially correct for any position or pointing errors of a radiation beam B received from a radiation source SO. Put differently, the beam steering unit BSU may be considered to be arranged to align a received radiation beam B with a nominal optical path through the illumination system IL.

An optical system 100 according to an embodiment of the present disclosure is now described with reference to Figures 3 to 4B. The optical system 100 is for use in an imaging apparatus such as, for example, the lithographic apparatus LA described above with reference to Figures 1 and 2. For example, the optical system 100 may be, comprise or form part of the illumination system IL of the lithographic apparatus LA described above with reference to Figures 1 and 2.

The optical system 100 is arranged to receive a radiation beam 102 at an inlet 104 and to direct the radiation beam 102 to an illumination region 106 via an optical path, as described further below. In use, a patterning device MA of a lithographic apparatus LA may be disposed in the illumination region 106. The optical system 100 comprises a position sensor 108 and adjustable optics 110.

The position sensor 108 is operable to determine a position and/or orientation of at least a part of the optical system 100. For example, the position sensor 108 may be operable to determine a position and/or orientation of a part of the optical system 100 to which it is attached.

The adjustable optics 110 in this example comprises two mirrors 112, 114. The adjustable optics 110 is configured to control the optical path of the received radiation beam 102. In particular, the adjustable optics 110 is configured to control the optical path of the received radiation beam 102 in dependence on a determined position and/or orientation of the part of the optical system 100 (as determined by the position sensor 108).

The optical system 100 further comprises a controller 116. The controller 116 is operable to receive a first signal s₁ from the position sensor 108 indicative of a position and/or orientation of a part of the optical system 100. The controller 116 is further operable to generate and send a control signal sc to the adjustable optics 110, the control signal dependent on the first signal(s) s₁.

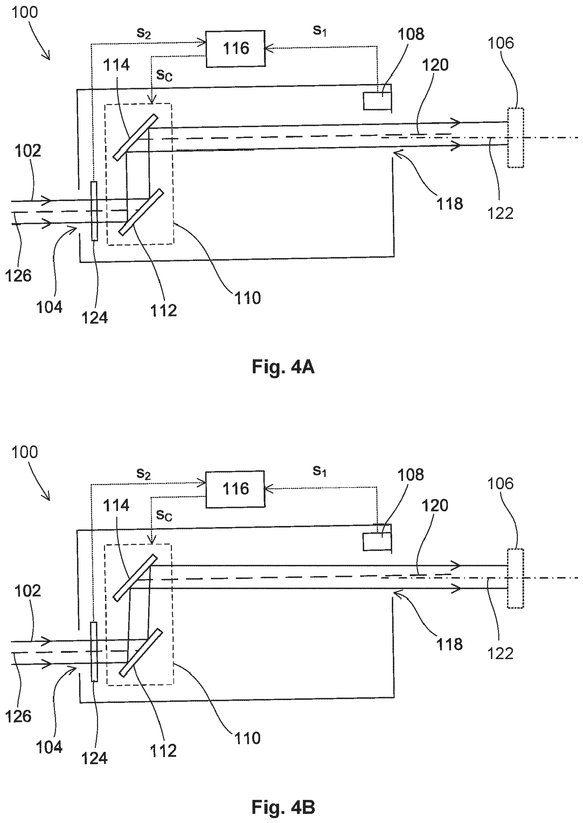

The adjustable optics 110 may be configured to control the optical path of the received radiation beam 102 in dependence on a determined position and/or orientation of the part of the optical system 100 to at least partially correct for any variations in a spatial and/or angular distribution of the radiation at the illumination region 106 that result from any deviations in the determined position and/or orientation from a nominal position, as now discussed with reference to Figures 4A to 4B.

The radiation beam 102 may exit the optical system 100 at an outlet 118. After exiting the outlet 118 the radiation beam 102 may propagate to the illumination region 106. The radiation beam may be aligned to the optical system 100 at the outlet 118. This is indicated schematically in Figures 3 to 4B as the radiation beam 102 being aligned with an exit axis 120 of the optical system 100.

In use, the optical system 100 may have a nominal position. When disposed in the nominal position, the position and direction of radiation delivered to the illumination region 106 may be optimum. The optical system 100 is shown in a nominal position and configuration in Figure 3. In this nominal position, as shown very schematically in Figure 3, the exit axis 120 of the optical system 100 is aligned with an axis 122 of the illumination region 106.

However, in use, the optical system 100 may be subject to vibrations. For example, for embodiments wherein the optical system comprises, is, or forms part of, an illumination system IL for a lithographic apparatus LA, movement of other parts of the lithographic apparatus LA in use (for example the mask support MT and/or the substrate support WT) may cause some vibrations of the optical system 100. In turn, this may lead to deviations in the position and/or orientation of the optical system 100 relative to the illumination region 106, as determined by the position sensor 108.

Any such deviations in the determined position and/or orientation (for example of position sensor 108) from a nominal position may result in sub-optimal irradiation of the illumination region 106 (see Figure 4A) and the adjustable optics 110 can be used to at least partially correct for any such variations (see Figure 4B).

For example, the optical system 100 may be subject to vibrations that cause the position sensor 108 to move up and down in the plane of Figure 3. Any deviations of the position sensor 108 (and therefore the part of the optical system 100 to which it is attached) may result in a misalignment of the exit axis 120 of the optical system 100 relative to the axis 122 of the illumination region 106. For example, as shown in Figure 4A, if the optical system 100 moves such that the position sensor 108 moves up, the exit axis 120 of the optical system 100 may be at a non-zero angle to the axis 122 of the illumination region 106. If the radiation beam 102 is aligned to the exit axis 120 of the optical system 100, it will no longer be aligned with the axis 122 of the illumination region 106. As a result, there will be a change in the angular distribution of radiation at the illumination region 106 (relative to the angular distribution of radiation at the illumination region 106 when the optical system 100 is in the nominal position of Figure 3), which is undesirable. However, as shown in Figure 4B, the optical system 100 is arranged to correct for this using the adjustable optics 110.

In particular, by suitable rotation of the two mirrors 112, 114 of the adjustable optics (under the control of control signal s_{C}), the radiation beam 102 may be aligned to the axis 122 of the illumination region 106.

In the example shown in Figures 4A and 4B, the optical system 100 is explained as being arranged to correct for any up and down motion of the position sensor 108 this using the adjustable optics 110. It will be appreciated that this is a simplified example shown in Figures 4A and 4B merely to illustrate the principle of the correction applied by the adjustable optics 110. Note that in practice the adjustable optics 110 are operable to correct for any motion (i.e., changes in position and/or orientation) of the position sensor(s) 108 in all six degrees of freedom.

To the extent possible, the adjustable optics 110 may be configured such that a spatial and/or angular distribution of the radiation 102 at the illumination region 106 is generally independent of the determined position and/or orientation of the part of the optical system 100 (as determined by the position sensor 108). That is, the position sensor 108 and adjustable optics 110 form a feedback loop that automatically corrects for movement of the optical system 100 (as shown in Figure 4B).

In contrast to known arrangements of illumination systems IL for lithographic apparatus wherein a radiation beam is generally aligned with the illumination system IL (for example using a beam steering unit BSU), the optical system 100 shown in Figures 3 to 4B is arranged to create a misalignment between the radiation beam 102 and the optical system 100. In particular, this misalignment so as to automatically correct for movement of the optical system 100 (as shown in Figure 4B).

During use, if the at least a part of the optical system 100 moves then the spatial and/or angular distribution of radiation 102 delivered to the illumination region 106 may be changed, which may be undesirable. The optical system 100 shown in Figures 3 to 4B is advantageous, as it allows for any movement (or variation in position and/or orientation) of the at least a part of the optical system 100 to be corrected for such that the radiation 102 is delivered to the illumination region 106 accurately.

The optical system 100 may be suitable for use in a lithographic apparatus LA. The optical system may comprise, be, or form part of an illumination system IL for an imaging apparatus (for example a lithographic apparatus LA). Such an illumination system IL may be operable to condition a received radiation beam (for example from a radiation source or laser) and so as to deliver the received radiation to an illumination region (in which a mask or reticle MA may be disposed) with a desired or required spatial and angular distribution.

The optical system 100 is particularly beneficial for use in the illumination system IL of a lithographic apparatus LA, as now discussed.

For a precision imaging apparatus such as a lithographic apparatus LA it can be extremely important to illuminate a patterning device MA (also referred to as a mask or a reticle) with radiation having well-defined spatial and angular distributions. For example, it is generally desirable to illuminate the patterning device MA with a generally uniform spatial distribution to ensure that the dose of radiation delivered to a substrate W (for example a resist-coated silicon wafer) is well controlled. In turn, this can result in better critical dimension (CD) control. The angular distribution of radiation at the illumination region (in which the patterning device MA is disposed) may also be referred to as an illumination mode or a pupil. The angular distribution radiation at the illumination region (in which the patterning device MA is disposed) describes how a cone of radiation that illuminates each portion of the patterning device MA is filled. This can be described by the intensity of radiation in an entrance pupil of the projection optics PS arranged to image the patterning device MA onto the substrate W. It is generally known that illuminating a patterning device MA with an illumination mode wherein peripheral portions of the entrance pupil are illuminated and central portions of the entrance pupil are not illuminated (for example annular illumination modes and dipole illumination modes) can generally improve the contrast of the image formed on the substrate for a range of different features (relative, for example, to a full pupil fill illumination).

Any variation in the position and/or angle of the radiation delivered to a patterning device MA may affect the imaging of the patterning device MA onto the substrate W. In particular, any pointing error of the radiation delivered to the illumination region can result in asymmetric numerical aperture (NA) clipping, particularly for illumination modes in which the outermost portions of the entrance pupil are illuminated (for example extreme dipoles). In turn, this will adversely affect the imaging of the patterning device MA, which is undesirable. It will be appreciated that the projection system PS will, in general, provide numerical aperture clipping of the radiation beam B patterned by the mask MA. In practice, the lithographic apparatus LA is used to image features which are small in comparison to the wavelength of the radiation beam B and therefore the image of the pattern formed on the wafer W is typically diffraction-limited, formed only from a very small number of diffraction orders of the radiation that has interacted with the mask MA. However, any asymmetric numerical aperture clipping of the radiation beam by the projection system PS can result in alignment errors. Slow changes in the (symmetry) of the NA clipping result in position errors (i.e., a moving average) of the image formed on the wafer W whereas fast changes in the NA clipping are smeared out, contributing to a blurring (an increase in mean standard deviation) of features formed on the wafer W. It will be appreciated that as used here "slow" may mean over time scales that are large in comparison to an exposure time of the wafer and "fast" may mean over time scales that are smaller than an exposure time of the wafer.

As stated above, in the absence of the feedback loop provided by the position sensor 108 and the adjustable optics (via controller 116), in the vicinity of the outlet 118, the radiation beam 102 may be aligned to an exit axis 120 of the optical system 100. This may be achieved either by providing the radiation beam 102 to the optical system 100 such that when the optical system 100 is in a nominal position or configuration the radiation beam 102 is aligned to an exit axis 120 of the optical system 100. Alternatively, in some embodiments, this may also be achieved using the adjustable optics 110, as now discussed.

The optical system 100 shown in Figure 3 further comprises a radiation beam measurement sensor 124. The radiation beam measurement sensor 124 is operable to determine a position and/or a direction of the received radiation beam 102 relative to at least a part of the optical system 100. The adjustable optics 110 is operable to control the optical path of the received radiation beam 102 in dependence on the determined position and/or direction of the received radiation beam 102 (as determined by the radiation beam measurement sensor 124) relative to said at least a part of the optical system 100.

The controller 116 is further operable to receive a second signal s₂ from the radiation beam measurement sensor 124 that is indicative of a position and/or or a direction of the received radiation beam 102 relative to the optical system 100. Furthermore, for such embodiments, the control signal sc is dependent on the first signal s₁, the second signal s₂, or both the first signal s₁ and the second signal s₂.

That is, the radiation beam measurement sensor 124 may be used to align a received radiation beam 102 to the optical system 100 (using the adjustable optics 110) such that when the optical system 100 is in a nominal position or configuration the radiation beam 102 is aligned to an exit axis 120 of the optical system 100. This can correct for any alignment and/or pointing errors of a radiation beam 102 received by the optical system 100. That is, this can correct for any misalignment between the radiation beam 102 received by the optical system 110 and an entrance axis 126 of the optical system 100.

However, with such an arrangement in the absence of the feedback loop described above using the position sensor 108 and the adjustable optics, if the optical system 100 itself moves, then the radiation beam 102 will also move and therefore the radiation beam 102 will not be accurately aligned with the illumination region 106 (as shown in Figure 4A and described above). However, since the adjustable optics 110 are configured to control the optical path of the received radiation beam 102 in dependence on a determined position and/or orientation of the part of the optical system 100, any such misalignment between the radiation beam 102 and the illumination region 106 can be corrected for.

In this embodiment, the at least a part of the optical system 100 relative to which the radiation beam measurement sensor 124 is operable to determine a position and/or a direction of the received radiation beam 102 is a different part of the optical system 100 to the part of the optical system 100 that the position sensor 108 is operable to determine a position and/or orientation of. For example, in this embodiment, the radiation beam measurement sensor 124 is operable to determine a position and/or a direction of the received radiation beam 102 relative to a part of the optical system 100 proximate the inlet 104 and the position sensor 108 is operable to determine a position and/or orientation of a part of the optical system 100 proximate the illumination region 106. In other embodiments, the part of the optical system 100 relative to which the radiation beam measurement sensor 124 is operable to determine a position and/or a direction of the received radiation beam 102 may be the same part of the optical system 100 that the position sensor 108 is operable to determine a position and/or orientation of.

Furthermore, in this embodiment the position sensor 108 is optically downstream of the adjustable optics 110. Advantageously, this may allow for the position sensor 108 to be as close as possible to the illumination region 106. In turn, this may result in more accurate control of the spatial and angular distributions of the radiation 102 at the illumination region 106.

Note that the same actuatable or adjustable optical elements (for example mirrors 112, 114 of the adjustable optics 110) may be used to both: (a) control the optical path of the received radiation beam 102 in dependence on a determined position and/or orientation of part of the optical system (as determined by position sensor 108) and; and (b) control the optical path of the received radiation beam 102 in dependence on a determined position and/or a direction of the received radiation beam 102 (as determined by the radiation beam measurement sensor 124). Alternatively, a first set of optical elements may be provided to control the optical path of the received radiation beam 102 in dependence on a determined position and/or orientation of part of the optical system 100 (as determined by position sensor 108) and a second set of optical elements may be provided to control the optical path of the received radiation beam in dependence on a determined position and/or direction of the received radiation beam (as determined by the radiation beam measurement sensor 124). For such embodiments, the adjustable optics 110 may be considered to comprise both the first set of optical elements and the second set of optical elements.

In some alternative embodiments, the optical system 100 may comprise a plurality of position sensors 108, each operable to determine a position and/or orientation of at least a part of the optical system 100. For example, each position sensor 108 may be operable to determine a position and/or orientation of a part of the optical system 100 to which it is attached. The plurality of position sensors 108 may be disposed in different parts of the optical system 100, for example but not limited to, at the relay lens RL or at the masking device MD. For such embodiments having a plurality of position sensors 108, the adjustable optics 110 may be operable to control the optical path of the received radiation beam 102 in dependence on a position and/or orientation of a part of the optical system 100 determined by each of the plurality of position sensors 108.

This may allow for more complicated distortions of the optical system 100 to be corrected for. For example if the optical system 100 does not merely oscillate as a whole but is subject to vibration or oscillation modes that correspond to a distortion of the optical system 100 then a plurality of position sensors may allow for the effect of such oscillation modes on a spatial and/or angular distribution of radiation delivered to the illumination region 106 to be at least partially corrected for.

The at least one position sensor 108 is operable to determine a position and/or orientation of at least a part of the optical system 100. Such a determination may be a direct measurement of position and/or orientation. Alternatively, the determination may be indirect. For example, the position sensor 108 may measure another quantity (for example acceleration) from which a position can be determined. Any suitable type of position sensor 108 may be used. In general, each position sensor determines a position and/or orientation of the part of the optical system 100 relative to a reference frame. The reference frame may be any frame in which the illumination region 106 (also referred to in the art as the illumination slit or just slit) is stationary.

In some embodiments, the at least one position sensor 108 is operable to determine a position and/or orientation of at least a part of the optical system in all six degrees of freedom. These degrees of freedom may be, for example, an x position, a y position, a z position, an Rx-rotation, an Ry-rotation, and an Rz-rotation.

In some embodiments the position sensor(s) 108 comprise one or more accelerometers. Such embodiments determine the position and/or orientation of parts of the optical system 100 relative to an inertial frame.

In one embodiment, the or each position sensor 108 may comprise at least two accelerometers arranged to determine an acceleration of a part of the optical system 100 in at least in two directions that are generally orthogonal to the optical path of the radiation beam 102. This allows a position of the part of the optical 100 to be determined in said two directions that are generally orthogonal to the optical path. In one embodiment, the or each position sensor 108 may comprise at least three accelerometers arranged to determine an acceleration of a part of the optical system 100 in three linearly independent directions. This allows a position of the part of the optical 100 to be determined in said three linearly independent directions.

In some embodiments the or each accelerometer is operable to determine acceleration and/or position and has three degrees of freedom. In one embodiment, the position sensor 108 comprises two or three accelerometers, each arranged to determine three degrees of freedom. Advantageously, this may allow the position sensor 108 to determine a position and/or orientation of at least a part of the optical system in all six degrees of freedom.

Alternative position sensors may include interferometric sensors. Such interferometric sensors may, for example, be of the type used to monitor the position of a reticle stage MT or wafer stage WT in a lithographic apparatus LA.

In some embodiments, the optical system 100 may comprise beam steering optics (for example of the type provided by the beam steering unit BSU of Figure 2) that are arranged to direct the radiation 102 along an adjustable optical path.

The beam steering optics may receive a radiation beam B (for example from a radiation source SO). The beam steering optics may, for example, comprise two rotatable mirrors BS1, BS2. By rotating the mirrors BS1, BS2 a position and direction of the radiation beam B downstream of the beam steering optics BSU can be controlled. For such embodiments, the adjustable optics 110 of the optical system 100 may comprise the beam steering optics BSU.

Additionally or alternatively, in some embodiments, the optical system 100 may comprise pupil shaping optics PSO (for example of the type shown in Figure 2 and described above) that are operable to control an angular distribution of radiation delivered to the illumination region 106. That is, the illumination region 106 may be irradiated using different illumination modes or pupils by selecting one or a plurality of configurations of the pupil shaping optics. For such embodiments, the adjustable optics 110 may comprise the pupil shaping optics PSO. It will be appreciated by those skilled in the art, that the mirror array arranged in the pupil shaping optics PSO may be used to control the radiation beam in dependence of the position and / or direction of the radiation beam as measured by the sensors 108, 124.

Some embodiments of the present disclosure relate to a new lithographic apparatus LA that is generally of the type shown in Figures 1 and 2, and as described above, the lithographic apparatus LA comprising: the optical system 100 of the type shown in Figures 3 to 4B, and as described above, wherein the support structure MT (reticle stage) is configured to support a patterning device MA such that the patterning device MA is positionable in the illumination region 106. Such a novel lithographic apparatus LA is advantageous, as it allows for any movement (or variation in position and/or orientation) of the at least a part of the optical system 100 to be corrected for such that the radiation B is delivered to the illumination region 106 (where the patterning device MA is, in use, positioned) more accurately. In turn, as explained above, any variation in the position and/or angle of the radiation B delivered to a patterning device MA may affect the imaging of the patterning device ME onto the substrate W. In particular, any pointing error of the radiation B delivered to the illumination region 106 can result in asymmetric numerical aperture (NA) clipping, particularly for illumination modes in which the outermost portions of the entrance pupil are illuminated (for example extreme dipoles). In turn, this will adversely affect the imaging of the patterning device MA, which is undesirable. The new lithographic apparatus LA allows for a greater range of illumination modes to be used without suffering from such problems (for example asymmetric NA clipping). Additionally or alternatively, the new lithographic apparatus LA allows for larger movement or vibrations of parts of the lithographic apparatus LA without suffering from such problems (for example asymmetric NA clipping). In turn, tolerating larger movement or vibrations can, advantageously, allow for an increase in throughput of the lithographic apparatus LA and the associated reduction in manufacturing costs per wafer W.

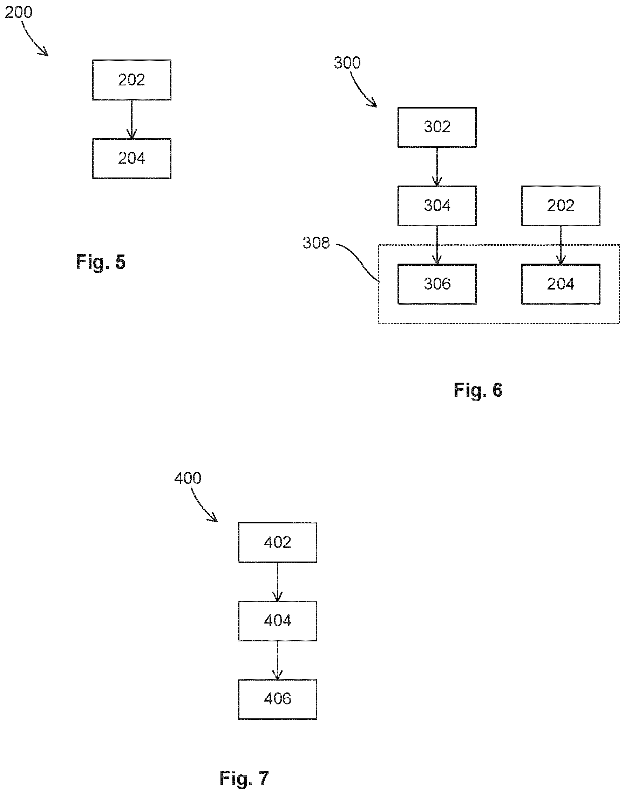

Some embodiments of the present disclosure relate to a method 200 of providing radiation 102 to an illumination region 106 via an optical system 100, as now discussed with reference to Figures 5 and 6.

The method 200 comprises a step 202 of determining a position and/or orientation of at least a part of the optical system 100. The method 200 further comprises a step 204 of adjusting at least one optical element 112, 114 in the optical system 100 in dependence on a determined position and/or orientation of a part of the optical system 100.

The method 200 shown in Figure 5 may be carried out using the optical system 100 shown in Figures 3 to 4B. The method 200 shown in Figure 5 is advantageous as it allows for any movement (or variation in position and/or orientation) of the at least a part of the optical system 100 to be corrected for such that the radiation 102 is delivered to the illumination region 106 accurately.

The method 200 shown in Figure 5 is particularly beneficial for use in illuminating a patterning device MA (also referred to as a reticle or a mask) as part of a lithographic exposure process. For example, any variation in the position and/or angle of the radiation delivered to a patterning device MA may affect the imaging of the patterning device MA onto the substrate W. In particular, any pointing error of the radiation delivered to the illumination region 106 can result in asymmetric numerical aperture (NA) clipping, particularly for illumination modes in which the outermost portions of the entrance pupil of a projection system PS are illuminated (for example extreme dipoles). In turn, this will adversely affect the imaging of the patterning device MA, which is undesirable.

Adjusting at least one optical element 112, 114 in the optical system 100 in dependence on a determined position and/or orientation of a part of the optical system 100 may comprise at least partially correcting for any variations in a spatial and/or angular distribution of the radiation at the illumination region 106 that result from any deviations in the determined position and/or orientation from a nominal position.

For example, the optical system 100 may have a nominal position. When disposed in the nominal position, the position and direction of radiation 102 delivered to the illumination region 106 may be optimum. In use, the optical system 100 may be subject to vibrations. For example, for embodiments wherein the optical system 100 comprises, is, or forms part of an illumination system IL for a lithographic apparatus LA, movement of other parts of the lithographic apparatus LA in use may cause some vibrations of the optical system 100.

Any deviations in the determined position and/or orientation of the optical system 100 from a nominal position may result in sub-optimal irradiation of the illumination region 106 and therefore, for such embodiments, the at least one optical element 112, 114 (which may be referred to as adjustable optics 110) are used to at least partially correct for any variations.

To the extent possible, adjusting the at least one optical element 112, 114 in the optical system 100 in dependence on a determined position and/or orientation of a part of the optical system 100 may be performed such that a spatial and/or angular distribution of the radiation at the illumination region 106 is generally independent of the determined position and/or orientation of the part of the optical system 100.

Another method 300 of providing radiation 102 to an illumination region 106 via an optical system 100 is shown schematically in Figure 6. The method 300 shown in Figure 6 comprises the steps 202, 204 of the method 200 shown in Figure 5 and described above.

The method 300 shown in Figure 6 further comprises the step 302 of providing a radiation beam 102.

The method 300 shown in Figure 6 further comprises the step 304 of determining a position and/or a direction of the provided radiation beam 102 relative to at least a part of the optical system 100.

The method 300 shown in Figure 6 further comprises the step 306 of adjusting at least one optical element 112, 114 in the optical system 100 in dependence on a determined position and/or direction of the provided radiation beam 102 relative to said at least a part of the optical system 100.

Therefore, in this embodiment, the method 300 may comprise a step 308 of adjusting at least one optical element 112, 114 in the optical system 100 in dependence on both: (a) a determined position and/or orientation of part of the optical system 110; and (b) a determined position and/or a direction of the received radiation beam 102.

Either of the methods 200, 300 shown in Figures 5 and 6 may comprise determining a position and/or orientation of a plurality of parts of the optical system 100; and adjusting at least one optical element 112, 114 in the optical system 100 in dependence on the determined positions and/or orientations of each of the plurality of parts of the optical system 100. This may allow for more complicated distortions of the optical system 100 to be corrected for. For example, if the optical system 100 does not merely oscillate as a whole but is subject to vibration or oscillation modes that correspond to a distortion of the optical system 100.

With either of the methods 200, 300 shown in Figures 5 and 6 at least one part of the optical system 100 the position and/or orientation of which is determined is optically downstream of the at least one optical element 112, 114 adjusted in dependence thereon. Advantageously, this may allow for the at least one part of the optical system 100 the position and/or orientation of which is determined to be as close as possible to the illumination region 106. In turn, this may result in more accurate control of the spatial and angular distributions of the radiation 102 at the illumination region 106.

Either of the methods 200, 300 shown in Figures 5 and 6 may further comprise conditioning the radiation beam 102 so as to control a spatial and/or an angular distribution of radiation delivered to the illumination region 106.

Some embodiments of the present disclosure relate to a lithographic exposure method 400, as now discussed with reference to Figure 7.

The lithographic exposure method 400 comprises a step 402 of providing a patterning device MA in an illumination region 106.

The lithographic exposure method 400 further comprises a step 404 of providing radiation to the illumination region 106 via an optical system 100 using the method 200, 300 shown in Figure 5 or Figure 6 so as to form a patterned radiation beam.

The lithographic exposure method 400 further comprises a step 406 of collecting the patterned radiation beam and using it to form an image of the patterning device MA on a substrate W.

The lithographic exposure method shown in Figure 7 is advantageous, as it allows for any movement (or variation in position and/or orientation) of the at least a part of the optical system 100 to be corrected for such that the radiation 102 is delivered to the illumination region 106 (where the patterning device MA is, in use, provided) more accurately. In turn, as explained above, any variation in the position and/or angle of the radiation 102 delivered to a patterning device MA may affect the imaging of the patterning device MA onto the substrate W. In particular, any pointing error of the radiation delivered to the illumination region 106 can result in asymmetric numerical aperture (NA) clipping (at the step 406 of collecting the patterned radiation beam), particularly for illumination modes in which the outermost portions of the entrance pupil of the projection system PS are illuminated (for example extreme dipoles). In turn, this will adversely affect the imaging of the patterning device MA, which is undesirable. The lithographic exposure method 400 shown in Figure 7 allows for a greater range of illumination modes to be used without suffering from such problems (for example asymmetric NA clipping). Additionally or alternatively, the lithographic exposure method 400 shown in Figure 7 allows for larger movement or vibrations of parts of the lithographic apparatus LA without suffering from such problems (for example asymmetric NA clipping). In turn, tolerating larger movement or vibrations can, advantageously, allow for an increase in throughput of the lithographic apparatus LA and the associated reduction in manufacturing costs per wafer W.

In some embodiments of the lithographic exposure method 400 shown in Figure 7, the exposure may be a scanning exposure such that: (a) the step 402 of providing the patterning device MA in the illumination region 106 may comprise moving the patterning device MA through the illumination region 106; and (b) the step 406 of forming an image of the patterning device MA on the substrate W may comprise moving the substrate W such that the image of the patterning device MA is generally stationary relative to the substrate W.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals ( e.g.,carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Aspect of the invention are set out in the clauses below.
1. An optical system for use in an imaging apparatus, the optical system arranged to receive a radiation beam (provided by a radiation source) at an inlet and to direct the radiation beam to an illumination region via an optical path, the optical system comprising: at least one position sensor operable to determine a position and/or orientation of at least a part of the optical system; and adjustable optics configured to control the optical path of the received radiation beam in dependence on a determined position and/or orientation of the part of the optical system.
2. The optical system of clause 1, wherein the adjustable optics is configured to control the optical path of the received radiation beam in dependence on a determined position and/or orientation of the part of the optical system to at least partially correct for any variations in a spatial and/or angular distribution of the radiation at the illumination region that result from any deviations in the determined position and/or orientation from a nominal position.
3. The optical system of clause 1 or clause 2 further comprising at least one radiation beam measurement sensor operable to determine a position and/or a direction of the received radiation beam relative to at least a part of the optical system and wherein the adjustable optics is operable to control the optical path of the received radiation beam in dependence on the determined position and/or direction of the received radiation beam relative to said at least a part of the optical system.
4. The optical system of any preceding clause comprising a plurality of position sensors and wherein the adjustable optics is operable to control the optical path of the received radiation beam in dependence on a position and/or orientation of a part of the optical system determined by each of the plurality of position sensors.
5. The optical system of any preceding clause wherein the or each position sensor comprises one or more accelerometers.
6. The optical system of any preceding clause wherein at least one position sensor is optically downstream of the adjustable optics.
7. The optical system of any preceding clause further comprising a controller operable to:
   receive a first signal from the or each position sensor indicative of a position and/or orientation of a part of the optical system; and generate and send a control signal to the adjustable optics, the control signal dependent on the first signal(s).
8. The optical system of clause 7 when dependent either directly or indirectly on clause 3 wherein the controller is further operable to receive a second signal from the or each radiation beam measurement sensor indicative of a position and/or or a direction of the received radiation beam relative to the optical system; and wherein the control signal is dependent on the first signal(s) and the second signal.
9. The optical system of any preceding clause comprising beam steering optics that are arranged to direct the radiation along an adjustable optical path.
10. The optical system of clause 9 wherein the adjustable optics comprises the beam steering optics.
11. The optical system of any preceding clause comprising pupil shaping optics that are operable to control an angular distribution of radiation delivered to the illumination region.
12. The optical system of clause 11 wherein the pupil shaping optics comprises a mirror array comprising a plurality of independently adjustable mirrors.
13. The optical system of clause 11 or clause 12 wherein the adjustable optics comprises the pupil shaping optics.
14. A lithographic apparatus comprising: the optical system of any preceding clause operable to receive radiation and to direct at least a portion of the received radiation to the illumination region; a support structure configured to support a patterning device such that the patterning device is positionable in the illumination region; a substrate table configured to support a substrate; and a projection system operable to form an image of a patterning device supported by the support structure on a substrate supported by the substrate table.
15. A method of providing radiation to an illumination region via an optical system the method comprising: determining a position and/or orientation of at least a part of the optical system; and adjusting at least one optical element in the optical system in dependence on a determined position of a part of the optical system.
16. The method of clause 15 wherein adjusting at least one optical element in the optical system in dependence on a determined position and/or orientation of a part of the optical system comprises at least partially correcting for any variations in a spatial and/or angular distribution of the radiation at the illumination region that result from any deviations in the determined position and/or orientation from a nominal position.
17. The method of clause 15 or clause 16 further comprising: providing a radiation beam; determining a position and/or a direction of the provided radiation beam relative to at least a part of the optical system; and adjusting at least one optical element in the optical system in dependence on a determined position and/or direction of the provided radiation beam relative to said at least a part of the optical system.
18. The method of any one of clauses 15 to 17 comprising: determining a position and/or orientation of a plurality of parts of the optical system; and adjusting at least one optical element in optical system in dependence on the determined positions and/or orientations of each of the plurality of parts of the optical system.
19. The method of any one of clauses 15 to 18 wherein at least one part of the optical system the position and/or orientation of which is determined is optically downstream of the at least one optical element adjusted in dependence thereon.
20. The method of any one of clauses 15 to 19 further comprising conditioning the radiation beam so as to control a spatial and/or an angular distribution of radiation delivered to the illumination region.
21. A lithographic exposure method, the method comprising: providing a patterning device in an illumination region; providing radiation to the illumination region via an optical system using the method of any one of clauses 15 to 20 so as to form a patterned radiation beam; and collecting the patterned radiation beam and using it to form an image of the patterning device on a substrate.
22. The lithographic exposure method of clause 21, wherein the exposure is a scanning exposure such that providing the patterning device in the illumination region comprises moving the patterning device through the illumination region and forming an image of the patterning device on the substrate comprises moving the substrate such that the image of the patterning device is generally stationary relative to the substrate.
23. A lithographic apparatus comprising the optical system according to any of clauses 1 to 13.
24. The optical system according to any of clauses 1 to 13 and 23, wherein the at least one position sensor is provided at a relay lens and or at a masking device of the imaging apparatus.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An optical system for use in an imaging apparatus, the optical system arranged to receive a radiation beam at an inlet and to direct the radiation beam to an illumination region via an optical path, the optical system comprising:
at least one position sensor operable to determine a position and/or orientation of at least a part of the optical system; and
adjustable optics configured to control the optical path of the received radiation beam in dependence on a determined position and/or orientation of the part of the optical system.

2. The optical system of claim 1, wherein the adjustable optics is configured to control the optical path of the received radiation beam in dependence on the determined position and/or orientation of the part of the optical system to at least partially correct for any variations in a spatial and/or angular distribution of the radiation at the illumination region that result from any deviations in the determined position and/or orientation from a nominal position.

3. The optical system of claim 1 or claim 2, further comprising at least one radiation beam measurement sensor operable to determine a position and/or a direction of the received radiation beam relative to at least a part of the optical system and wherein the adjustable optics is operable to control the optical path of the received radiation beam in dependence on the determined position and/or direction of the received radiation beam relative to said at least a part of the optical system.

4. The optical system of any preceding claim comprising a plurality of position sensors and wherein the adjustable optics is operable to control the optical path of the received radiation beam in dependence on a position and/or orientation of a part of the optical system determined by each of the plurality of position sensors.

5. The optical system of any preceding claim, wherein the or each position sensor comprises one or more accelerometers.

6. The optical system of any preceding claim, wherein at least one position sensor is optically downstream of the adjustable optics.

7. The optical system of any preceding claim, further comprising a controller operable to:
receive a first signal from the or each position sensor indicative of a position and/or orientation of a part of the optical system; and
generate and send a control signal to the adjustable optics, the control signal dependent on the first signal(s).

8. The optical system of claim 7 when dependent either directly or indirectly on claim 3, wherein the controller is further operable to receive a second signal from the or each radiation beam measurement sensor indicative of a position and/or or a direction of the received radiation beam relative to the optical system; and wherein the control signal is dependent on the first signal(s) and the second signal(s).

9. The optical system of any preceding claim comprising pupil shaping optics that are operable to control an angular distribution of radiation delivered to the illumination region.

10. The optical system of claim 9 wherein the pupil shaping optics comprises a mirror array comprising a plurality of independently adjustable mirrors.

11. A method of providing radiation to an illumination region via an optical system the method comprising:
determining a position and/or orientation of at least a part of the optical system; and
adjusting at least one optical element in the optical system in dependence on a determined position of a part of the optical system.

12. The method of claim 11 wherein adjusting at least one optical element in the optical system in dependence on a determined position and/or orientation of a part of the optical system comprises at least partially correcting for any variations in a spatial and/or angular distribution of the radiation at the illumination region that result from any deviations in the determined position and/or orientation from a nominal position.

13. The method of claim 11 or claim 12 further comprising:
providing a radiation beam;
determining a position and/or a direction of the provided radiation beam relative to at least a part of the optical system; and
adjusting at least one optical element in the optical system in dependence on a determined position and/or direction of the provided radiation beam relative to said at least a part of the optical system.

14. The method of any one of claims 11 to 13 comprising:
determining a position and/or orientation of a plurality of parts of the optical system; and
adjusting at least one optical element in optical system in dependence on the determined positions and/or orientations of each of the plurality of parts of the optical system.

15. The method of any one of claims 11 to 14 wherein at least one part of the optical system the position and/or orientation of which is determined is optically downstream of the at least one optical element adjusted in dependence thereon.
